# EUROPEAN PATENT APPLICATION

(11) **EP 4 307 328 A1**
(43) Date of publication of application: **17.01.2024**
(21) Application number: 22767484.3
(22) Date of filing: 08.03.2022
(51) Int. Cl.: H01F 27/34, H01F 17/04, H01F 27/24, H01F 27/30, H05K 1/18

(54) **CIRCUIT BOARD HAVING COMPOSITE MAGNETIC COMPONENTS MOUNTED THEREON**

(30) Priority: 10.03.2021 KR 20210031242
(71) Applicant: LG Innotek Co., Ltd., Seoul 07796 (KR)
(72) Inventor: JEONG, Jong Sun, Seoul 07796 (KR); LEE, Jung Ki, Seoul 07796 (KR); LEE, Sang Won, Seoul 07796 (KR)
(74) Representative: Plasseraud IP
(86) International application number: PCT/KR2022/003280
(87) International publication number: WO 2022/191588

(57) **Abstract**

The present invention relates to a main magnetic component applicable to a core module of an electric vehicle. A composite magnetic component according to one embodiment of the present invention comprises: a transformer that converts power on an input side to transmit same to an output side, and has a first core and a first coil disposed in the first core; a ZVS inductor that refluxes a residual current to the input side without FET operation loss, and has a second core and a second coil disposed within the second core; an output inductor that removes the ripple of a current on the output side, and has a third core and a third coil disposed in the third core; and an EMI inductor that reduces electromagnetic noise of the current on the output side, and has a fourth core and a fourth coil disposed in the fourth core. Here, the second core, the third core, and the fourth core are made of different materials, and the first core and the second core are made of the same material.

## Description

### [Technical Field]

The present disclosure relates to a main magnetic component applicable to a core module of an electric vehicle.

### [Background Art]

An electric vehicle [xEV: a generic term for a hybrid electric vehicle (HEV),
a plug-in hybrid electric vehicle (PHEV), and an electric vehicle (EV)] includes a DC-DC converter, an on-board charger (OBC), and an inverter as core modules.

An electric vehicle is generally equipped with both a high-voltage battery for driving an electric motor and an auxiliary battery for supplying power to an electronic load, and the auxiliary battery may be charged by power of the high-voltage battery.

In this case, in order to charge the auxiliary battery, it is necessary to convert the DC power of the high-voltage battery into DC power corresponding to the voltage of the auxiliary battery through voltage drop. To this end, a DC-DC converter is used.

A high-voltage battery for an electric vehicle is designed to be slowly or quickly charged by external power. Here, an OBC is used as a charging device for converting AC electricity, which is external electricity, into DC power for the high-voltage battery.

These core modules may be configured such that two or more magnetic components are mounted on a circuit board in combination. In order to improve efficiency of use of electricity of an electric vehicle, research on technology related to combination and disposition of magnetic components for realizing system efficiency improvement, densification, and weight reduction has been increasingly conducted.

In particular, a compact structure and high efficiency are as important to large vehicle makers as price competitiveness. In order to realize a module having high performance characteristics in a confined space, high-density/high-performance design of a main magnetic component applied to the module needs to be performed.

### [Disclosure]

### [Technical Problem]

It is an object of the present disclosure to provide a circuit board on which a high-density and high-efficiency magnetic component composite module applicable to a core module of an electric vehicle is mounted.

In particular, the present disclosure provides a circuit board having composite magnetic components mounted thereon as a high-density and high-efficiency circuit board applicable to a DC-DC converter module.

### [Technical Solution]

A circuit board according to an embodiment of the present disclosure includes a board including a circuit unit formed thereon, a first module disposed on the board, and a second module disposed on the board so as to be adjacent to the first module and electrically connected to the first module.

Here, the first module includes a transformer including a first core and a first coil disposed in the first core and including primary and secondary coils in order to convert power on an input side and to transmit the converted power to an output side and a zero voltage switching (ZVS) inductor disposed adjacent to the transformer and including a second core and a second coil disposed in the second core in order to return a residual current to the input side.

In addition, the second module includes an output inductor including a third core and a third coil disposed in the third core in order to remove ripple components included in a current on the output side and an EMI inductor disposed adjacent to the output inductor and including a fourth core and a fourth coil disposed in the fourth core in order to reduce electric noise included in the current on the output side.

In one embodiment of the present disclosure, the first coil and the second coil are electrically connected to each other, and at least partially overlap each other in a first direction from the first core toward the second core. The third coil and the fourth coil are electrically connected to each other, and the third core and the fourth core at least partially overlap each other in a second direction perpendicular to the first direction. The first core includes a material identical to the material of the second core, and the second core includes a material different from the material of at least one of the third core and the fourth core.

Here, the first and second cores may include ferrite, and the third and fourth cores may include iron (Fe) and silicon (Si).

The circuit board according to at least one embodiment of the present disclosure further includes a first base at least partially disposed in the third core and configured to receive the third coil and a second base configured to receive the fourth core.

Here, in at least one embodiment of the present disclosure, the first base includes a third-coil-seating portion including a through-hole formed therein to allow a center leg of the third core to pass therethrough and configured to allow the third coil to be seated thereon, an inner side wall formed on the third-coil-seating portion so as to surround the through-hole, and an outer side wall formed on the outer circumference of the third-coil-seating portion and including a coil path slot formed therein to allow a flat wire coil escaping from the third core to pass therethrough.

In addition, in at least one embodiment of the present disclosure, the first base further includes a pair of third-core-outer-leg-slot portions formed in both sides of the third-coil-seating portion to allow a pair of outer legs of the third core to be inserted thereinto and located therein.

In addition, here, each of the third-core-outer-leg-slot portions may include a pair of first extension walls extending from the outer side wall in an outward direction, with the outer legs interposed therebetween.

In addition, in at least one embodiment of the present disclosure, the first base includes a first coil hole formed in one side of the third-coil-seating portion, and the third coil is disposed so as to be inserted into the first coil hole.

In addition, in at least one embodiment of the present disclosure, the first base further includes a fastening portion extending outside the third core from the third-coil-seating portion and including at least one fastening hole formed therein.

Meanwhile, in at least one embodiment of the present disclosure, the second base includes a fourth-core-seating portion configured to allow the fourth core to be seated and supported thereon and a fourth-coil-seating portion configured to allow the fourth coil to be seated thereon. The fourth-core-seating portion includes a pair of vertical walls disposed with the fourth core interposed therebetween and a seating protrusion protruding from the lower end of each of the vertical walls to support the fourth core seated thereon, and the fourth-coil-seating portion is formed so as to interconnect the pair of vertical walls in the fourth core.

Here, the second base may further include a pin portion extending from the fourth-coil-seating portion and including a pin hole formed therein.

Meanwhile, in at least one embodiment of the present disclosure, the first base and the second base are integrally formed with each other.

In at least one embodiment of the present disclosure, the first base, as another embodiment, may include a third-coil-seating portion including a through-hole formed therein to allow a center leg of the third core to pass therethrough and configured to allow the third coil to be seated thereon and a protruding portion protruding from one side of the third-coil-seating portion to a height lower than the thickness of a coil wire of the third coil and including a coil path slot formed therein to allow the third coil escaping from the third core to pass therethrough.

In addition, here, one end portion of the third coil may be disposed above the fourth core, and the circuit board may further include a bracket configured to surround an upper surface and both side surfaces of the fourth core in the state in which the third coil is disposed above the fourth core.

In at least one embodiment of the present disclosure, the third coil and the fourth coil are continuously formed using a single flat wire coil.

Here, the flat wire coil may be disposed so as to enter the third core, to be spirally wound around a center leg of the third core in a downward direction, to escape from the third core, and to be bent upward to penetrate the fourth core.

In addition, in at least one embodiment of the present disclosure, the third coil and the fourth coil are electrically connected to each other via the circuit unit.

In addition, the first module and the second module may be electrically connected to each other via the circuit unit.

In at least one embodiment of the present disclosure, the third core may further include nickel (Ni), and the fourth core may further include boron (B).

### [Advantageous Effects]

According to the present disclosure, a circuit board on which high-density and high-efficiency composite magnetic components are mounted may be obtained, and efficiency of use of electricity of an electric vehicle may be improved by applying the circuit board to a core module of the electric vehicle.

### [Description of Drawings]

FIGs. 1 to 3 show a first embodiment of an output inductor and an EMI inductor according to the present disclosure.
FIG. 4 shows an integrated base included in the first embodiment.
FIGs. 5 to 7 show a second embodiment of the output inductor and the EMI inductor according to the present disclosure.
FIG. 8 shows an embodiment of a first base included in the second embodiment.
FIG. 9 shows an embodiment of a second base included in the second embodiment.
FIGs. 10 to 12 show a third embodiment of the output inductor and the EMI inductor according to the present disclosure.
FIG. 13 shows an embodiment of a first base included in the third embodiment.
FIG. 14 shows an embodiment of a second base included in the third embodiment.
FIGs. 15 to 17 show a fourth embodiment of the output inductor and the EMI inductor according to the present disclosure.
FIG. 18 shows an embodiment of a first base included in the fourth embodiment.
FIG. 19 shows an embodiment of a bracket included in the fourth embodiment.
FIGs. 20 to 22 show an embodiment of a ZVS-inductor-integrated transformer according to the present disclosure.

### [Best Mode]

The present disclosure will now be described more fully hereinafter with reference to the accompanying drawings, in which various embodiments are shown. The examples, however, may be embodied in many different forms and should not be construed as being limited to the embodiments set forth herein. It is to be understood that the present disclosure covers all modifications, equivalents, and alternatives falling within the scope and spirit of the present disclosure.

The suffixes "module" and "unit" used herein to describe configuration components are assigned or used in consideration only of convenience in creating this specification, and the two suffixes themselves do not have any distinguishable meanings or roles from a physicochemical point of view.

While ordinal numbers including "first", "second", etc. may be used to describe various components, they are not intended to limit the components. These expressions are used only to distinguish one component from another component.

As used herein, the term "and/or" includes any and all combinations of one or more of the associated listed items. For example, the phrase "A and/or B" means "(A), (B), or (A and B)".

It will be understood that when an element is referred to as being "connected" or "coupled" to another element, it can be directly connected or coupled to the other element, or intervening elements may be present.

In the description of the embodiments, it will be understood that when an element, such as a layer (film), a region, a pattern or a structure, is referred to as being "on" or "under" another element, such as a substrate, a layer (film), a region, a pad or a pattern, the term "on" or "under" means that the element is directly on or under another element or is formed such that an intervening element may also be present. In addition, it will also be understood that criteria of "on" or "under" is on the basis of the drawing for convenience unless otherwise defined due to the characteristics of each of components or the relationship therebetween. The term "on" or "under" is used only to indicate the relative positional relationship between components and should not be construed as limiting the actual positions of the components.

For example, the phrase "B on A" merely indicates that B is illustrated in the drawing as being located on A, unless otherwise defined or unless A must be located on B due to the characteristics of A or B. In an actual product, B may be located under A, or B and A may be disposed in a leftward-rightward direction.

In addition, the thickness or size of a layer (film), a region, a pattern, or a structure shown in the drawings may be exaggerated, omitted or schematically drawn for the clarity and convenience of explanation, and may not accurately reflect the actual size.

The terminology used herein is for the purpose of describing particular embodiments only and is not intended to be limiting of exemplary embodiments of the disclosure. As used herein, the singular forms are intended to include the plural forms as well, unless the context clearly indicates otherwise. It will be further understood that the terms "include" or "have", when used herein, specify the presence of stated features, integers, steps, operations, elements, components, or combinations thereof, but do not preclude the presence or addition of one or more other features, integers, steps, operations, elements, components, or combinations thereof.

Unless otherwise defined, all terms used herein, which include technical or scientific terms, have the same meanings as those generally appreciated by those skilled in the art. The terms, such as ones defined in common dictionaries, should be interpreted as having the same meanings as terms in the context of pertinent technology, and should not be interpreted as having ideal or excessively formal meanings unless clearly defined in the specification.

A circuit board according to an embodiment of the present disclosure includes a board including a circuit unit formed thereon, a first module disposed on the board, and a second module disposed on the board so as to be adjacent to the first module and to be electrically connected to the first module.

Here, the board illustratively includes a PCB, and the circuit unit illustratively includes patterned plated wires formed to electrically connect various electronic elements on the PCB to each other.

The electrical connection between the first module and the second module is illustratively made through the circuit unit. That is, the first module and the second module may be electrically connected to each other via the plated wires on the board in a state of being mounted on the board.

In addition, the first module includes a transformer, which includes a first core and a first coil disposed in the first core and including primary and secondary coils in order to convert power on an input side and to transmit the converted power to an output side, and a ZVS inductor, which is disposed adjacent to the transformer and includes a second core and a second coil disposed in the second core in order to return a residual current to the input side.

In addition, the second module includes an output inductor, which includes a third core and a third coil disposed in the third core in order to remove ripple components included in a current on the output side, and an EMI inductor, which is disposed adjacent to the output inductor and includes a fourth core and a fourth coil disposed in the fourth core in order to reduce eletric noise included in the current on the output side.

Here, the first coil and the second coil may be electrically connected to each other, and may at least partially overlap each other in a first direction from the first core toward the second core. In addition, the third coil and the fourth coil may be electrically connected to each other, and the third core and the fourth core may at least partially overlap each other in a second direction perpendicular to the first direction. The electrical connection between the coils includes not only a case in which the corresponding coils are connected to each other in a manner of being formed so as to continuously extending using a single coil wire but also a case in which the corresponding coils are connected to each other via the circuit unit on the board.

Here, the material of the first core and the material of the second core may be identical to each other, and the material of the second core may be different from the material of at least one of the third core and the fourth core.

The third and fourth cores may include iron (Fe) and silicon (Si). In addition, the third core may further include nickel (Ni), and the fourth core may further include boron (B).

The third core is made of a material having relatively high saturated magnetic flux density (e.g. 1.6 T) and high DC-bias characteristics, and thus is suitable for high current (e.g. 100 A or more) and is capable of being miniaturized.

The fourth core is made of a material having high permeability (e.g. µi 30,000 at 100 kHz) and low loss characteristics, whereby inductance is improved by 50% compared to a core made of a crystalline metal and having the same size.

The first core and the second core are made of ferrite (e.g. Mn-Zn-based ferrite), whereby heat generation is reduced through low loss, and power density is increased.

Hereinafter, structures of the output inductor, the EMI inductor, the ZVS inductor, and the transformer according to embodiments will be described in detail with reference to the drawings.

### First Embodiment of Output Inductor and EMI Inductor

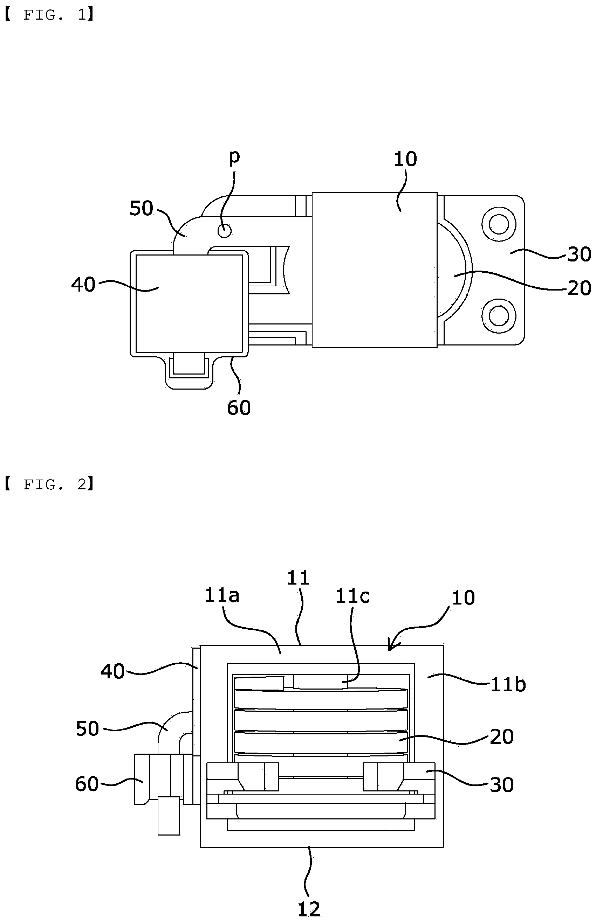

A first embodiment of the output inductor and the EMI inductor according to the present disclosure will be described with reference to FIGs. 1 to 4.

The output inductor includes a third core 10 and a third coil 20 disposed in the third core 10.

In addition, the EMI inductor includes a fourth core 40 and a fourth coil 50 disposed in the fourth core 40.

The third core 10 is formed in such a manner that an upper core portion 11 and a lower core portion 12 contact each other, and the upper core portion 11 and the lower core portion 12 are vertically symmetrical with each other with respect to the contact surface therebetween.

In detail, the upper core portion 11 of the third core 10 includes an upper plate 11a, a pair of outer legs 11b protruding from both sides of the upper plate 11a and extending vertically, and a center leg 11c disposed between the outer legs 11b.

The fourth core 40 is disposed adjacent to one side of the third core 10, and has a structure including a through-hole 31a formed therein to allow the fourth coil 50 to pass therethrough.

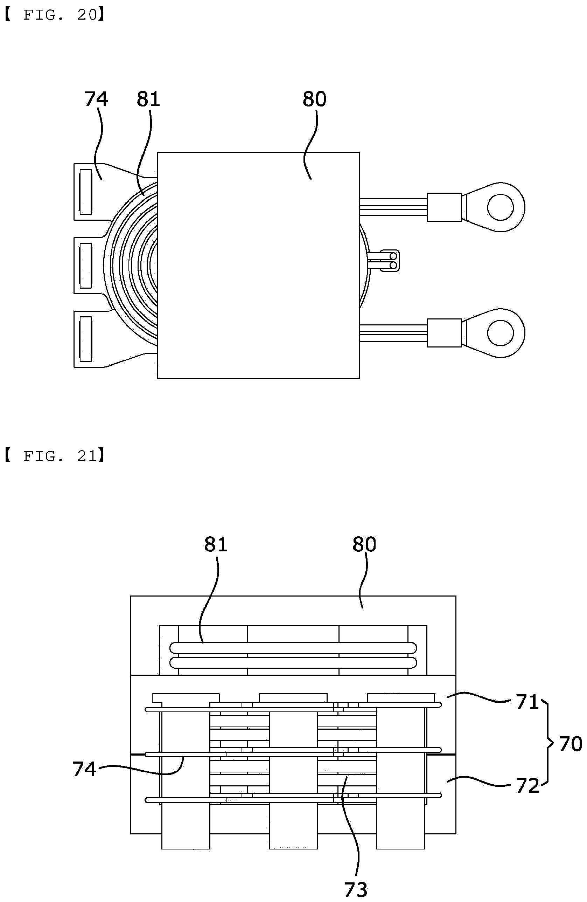

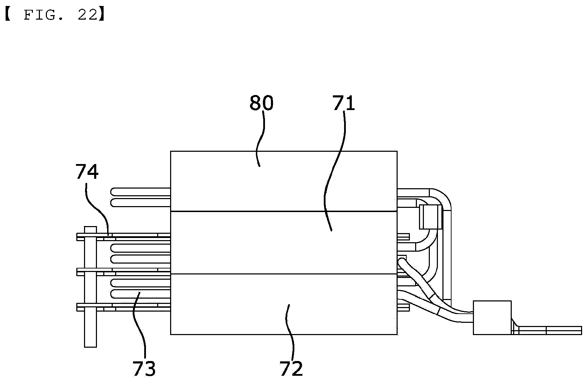

If a first core and a second core are stacked to overlap each other in a vertical direction (the first direction) in an embodiment to be described later with reference to FIGs. 20 to 22, the third core 10 and the fourth core 40 of this embodiment are disposed so as to overlap each other in a horizontal direction (the second direction). Such overlapping disposition is advantageous for increase in density and efficiency.

In this embodiment, the third coil 20 and the fourth coil 50 are continuously and integrally formed using a single flat wire coil.

That is, a single flat wire coil enters the third core 10 through one side of the third core 10, is spirally wound around the center leg 11c so as to extend downward, escapes from the third core 10 through the one side of the third core 10, is bent upward, and then is bent horizontally to penetrate the fourth core 40.

This embodiment includes an integrated base 30 and 60 in which a first base 30 and a second base 60 are integrally formed with each other, which will be described below.

First, the integrated base 30 and 60 includes a third-coil-seating portion 31, in which a through-hole 31a is formed to allow the center leg 11c of the third core 10 to pass therethrough and a flat surface is formed around the through-hole 31a to allow the third coil 20 to be seated thereon.

An inner side wall 32 is formed on the inner circumference of the third-coil-seating portion 31 so as to surround the through-hole 31a, and outer side walls 33a and 33b are formed on the outer circumference of the third-coil-seating portion 31.

A path slot 33c is formed in one side of each of the outer side walls 33a and 33b so that the flat wire coil escaping from the third core 10 after being spirally wound in the downward direction in the third core 10 passes through the outer side wall 33b.

Outer-leg-slot portions 34_1 and 34_2 in which the pair of outer legs 11b of the third core 10 is located are formed in both sides of the third-coil-seating portion 31.

In addition, the outer-leg-slot portions 34_1 and 34_2 include extension walls 34a, 34b, 34c, and 34d extending laterally from the outer side walls 33a and 33b.

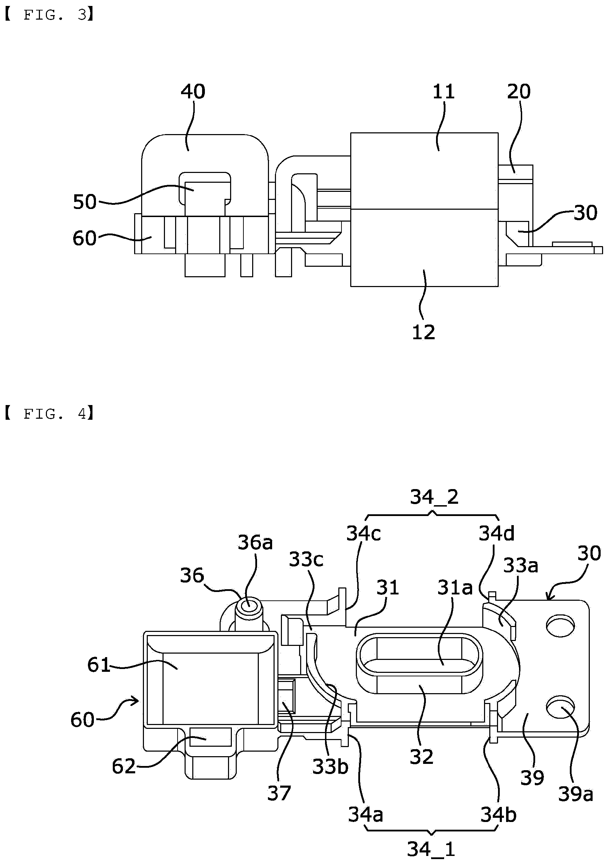

That is, as shown in FIG. 4, the first outer-leg-slot portion 34_1 includes a pair of extension walls 34a and 34b protruding and extending laterally from the outer side walls 33a and 33b so as to be disposed with one outer leg 11b interposed therebetween. In addition, the second outer-leg-slot portion 34_2 includes a pair of extension walls 34c and 34d protruding and extending laterally from the outer side walls 33a and 33b so as to be disposed with the other outer leg 11b interposed therebetween.

When the third core 10 and the integrated base 30 and 60 are assembled with each other, the center leg 11c of the third core 10 is inserted into the through-hole 31a in the third-coil-seating portion 31, and the pair of outer legs 11b of the third core 10 is located in the outer-leg-slot portions 34_1 and 34_2, respectively, whereby the third-coil-seating portion 31 is disposed in the third core 10.

Meanwhile, a fourth-core-seating portion 61 on which the fourth core 40 is seated is formed on one side of the integrated base 30 and 60.

The fourth-core-seating portion 61 includes a bottom surface and a circumferential wall formed on an edge of the bottom surface.

The fourth core 40 is seated on the fourth-core-seating portion 61 such that an imaginary straight line passing through the through-hole is parallel to the bottom surface.

A first coil hole 37 into which the flat wire coil is inserted is formed between the fourth-core-seating portion 61 and the third-coil-seating portion 31.

In addition, a pin portion 36 including a pin hole 36a is formed on one side of the fourth-core-seating portion 61, and a second coil hole 62 into which the flat wire coil is inserted is formed in the opposite side of the fourth-core-seating portion 61.

The flat wire coil, which continuously forms the third coil 20 and the fourth coil 50, passes through the first coil hole 37 from below to above, is bent horizontally to enter an upper portion in the third core 10, is spirally wound around the center leg 11c of the third core 10 in the downward direction, and then is seated on the bottom of the third-coil-seating portion 31. Subsequently, the flat wire coil passes through the path slot 33c in the outer side wall 33b, is bent upward, is bent horizontally to be placed on the pin portion 36, is bent horizontally via the pin portion 36 to pass through the through-hole in the fourth core 40, and then is bent downward to be inserted into the second coil hole 62. Here, a pin p may penetrate the flat wire coil placed on the pin portion 36 to be inserted into the pin hole 36a.

Meanwhile, the integrated base 30 and 60 includes a fastening portion 39 extending horizontally from one side of the third-coil-seating portion 31 and including a fastening hole 39a for fastening of a screw or the like.

### Second Embodiment of Output Inductor and EMI Inductor

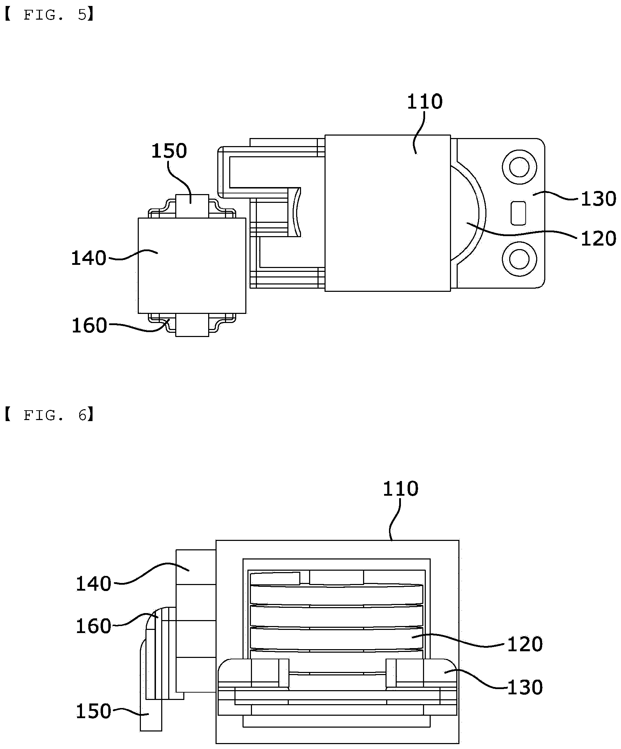

FIGs. 5 to 7 show a second embodiment of the output inductor and the EMI inductor, which will be described below.

In this embodiment, the structures of a third core 110 and a fourth core 140 are the same as those in the first embodiment, and therefore, detailed description thereof will be omitted.

Further, similar to the first embodiment, the third core 110 and the fourth core 140 are disposed so as to partially overlap each other in the horizontal direction (the second direction).

In this embodiment, a third coil 120 and a fourth coil 150 are not formed integrally or continuously, and a base is of a separation type, and includes a first base 130 and a second base 160.

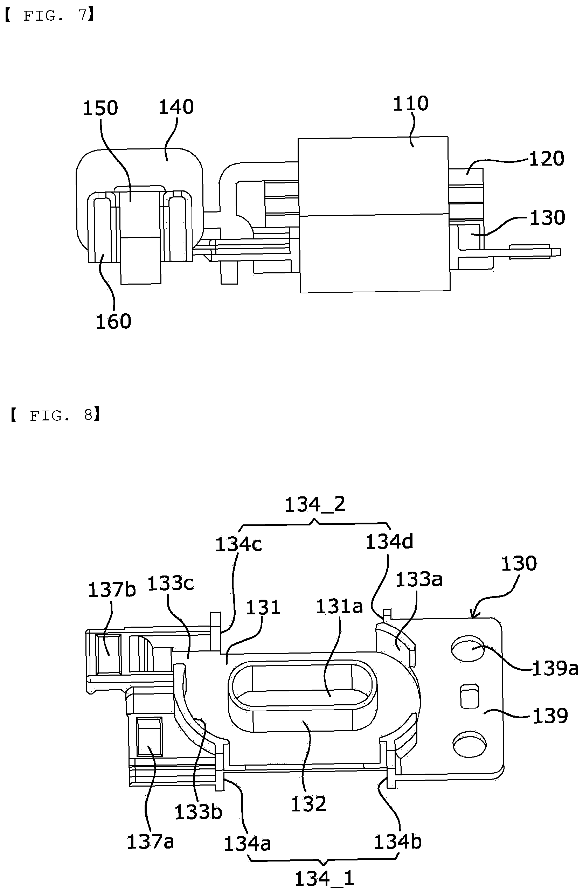

First, the first base 130 will be described in detail with reference to FIG. 8.

The first base 130 includes a third-coil-seating portion 131, in which a through-hole 131a is formed to allow a center leg of the third core 110 to pass therethrough and a flat surface is formed around the through-hole 131a to allow the third coil 120 to be seated thereon.

An inner side wall 132 is formed on the inner circumference of the third-coil-seating portion 131 so as to surround the through-hole 131a, and outer side walls 133a and 133b are formed on the outer circumference of the third-coil-seating portion 131.

A path slot 133c is formed in one side of the outer side wall 133b so that the flat wire coil escaping from the third core 110 after being spirally wound in the downward direction in the third core 110 passes through the outer side walls 133a and 133b.

Outer-leg-slot portions 134_1 and 134_2 in which a pair of outer legs of the third core 110 is located are formed in both sides of the third-coil-seating portion 131.

In addition, the outer-leg-slot portions 134_1 and 134_2 include extension walls 134a, 134b, 134c, and 134d extending laterally from the outer side walls 133a and 133b.

That is, as shown in FIG. 8, the first outer-leg-slot portion 134_1 includes a pair of extension walls 134a and 134b protruding and extending laterally from the outer side walls 133a and 133b so as to be disposed with one outer leg interposed therebetween. In addition, the second outer-leg-slot portion 134_2 includes a pair of extension walls 134c and 134d protruding and extending laterally from the outer side walls 133a and 133b so as to be disposed with the other outer leg interposed therebetween.

When the third core 110 and the first base 130 are assembled with each other, the center leg of the third core 110 is inserted into the through-hole 131a in the third-coil-seating portion 131, and the pair of outer legs of the third core 110 is located in the outer-leg-slot portions 134_1 and 134_2, respectively, whereby the third-coil-seating portion 131 is disposed in the third core 110.

A first coil hole 137a and a third coil hole 173b into which both end portions of the flat wire coil of the third coil 120 are inserted are formed in one side of the first base 130.

The flat wire coil forming the third coil 120 passes through the first coil hole 137a from below to above, is bent horizontally to enter an upper portion in the third core 110, is spirally wound around the center leg of the third core 110 in the downward direction, and then is seated on the bottom of the third-coil-seating portion 131. Subsequently, the flat wire coil passes through the path slot 133c in the outer side wall 133b, is bent upward, makes a U-turn to extend downward, and then is inserted into the third coil hole 173b.

Meanwhile, the first base 130 includes a fastening portion 139 extending horizontally from one side of the third-coil-seating portion 131 and including a fastening hole 139a for fastening of a screw or the like.

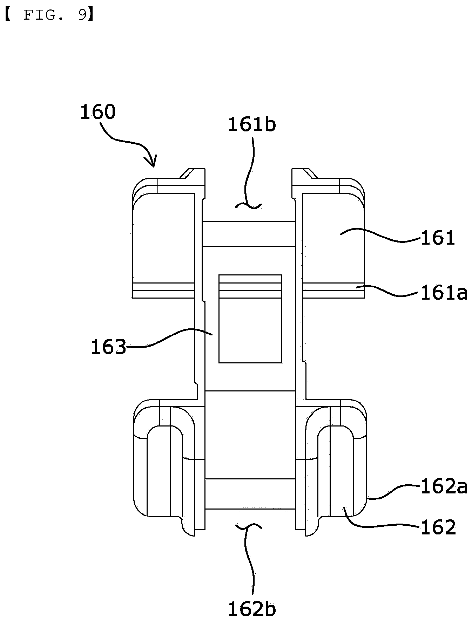

As shown in FIG. 9, the second base 160 includes fourth-core-seating portions 161, 161a, 162, and 162a, on which the fourth core 140 is seated and supported.

The fourth-core-seating portions 161, 161a, 162, and 162a include a pair of vertical walls 161 and 162 disposed with the fourth core 140 interposed therebetween, and seating protrusions 161a and 162a protruding from the lower ends of the respective vertical walls to allow the fourth core 140 to be seated and supported thereon.

In addition, the second base 160 includes a fourth-coil-seating portion 163, which penetrates the fourth core 140 and is formed to interconnect the pair of vertical walls 161 and 162 and on which the fourth coil 150 is seated.

In the second base 160, coil-receiving recesses 161b and 162b in which end portions of the fourth coil 150 are received are formed in the outer surfaces of the respective vertical walls.

The fourth coil 150 is made using a flat wire coil, and is seated and supported on the fourth-coil-seating portion 163. Both sides of the fourth coil 150 are bent downward to be received in the coil-receiving recesses 161b and 162b, respectively, and extend downward.

### Third Embodiment of Output Inductor and EMI Inductor

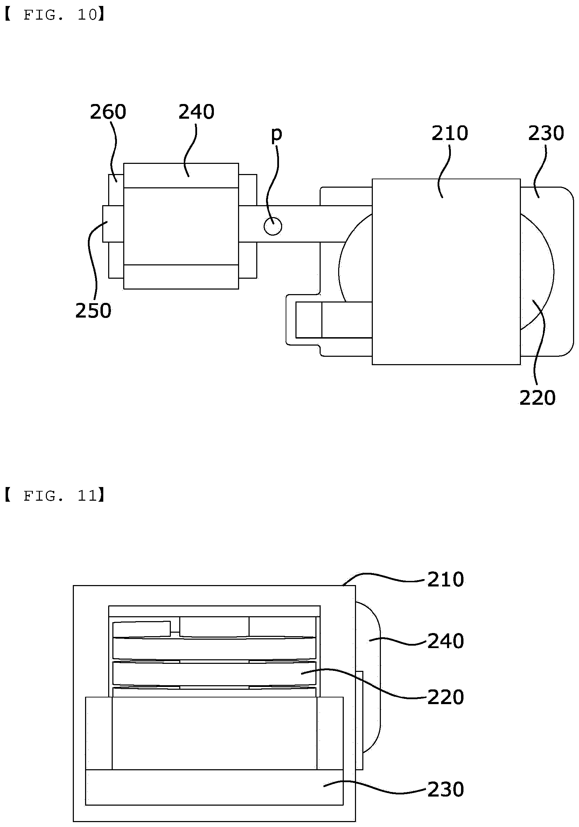

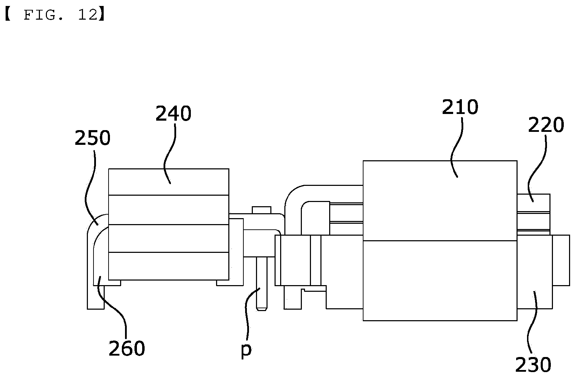

FIGs. 10 to 12 show a third embodiment of the output inductor and the EMI inductor, which will be described below.

In this embodiment, the structures of a third core 210 and a fourth core 240 are the same as those in the first embodiment, and therefore, detailed description thereof will be omitted.

In this embodiment, the third core 210 and the fourth core 240 are disposed so as to overlap each other in the horizontal direction (the second direction). However, unlike the first and second embodiments in which the penetration direction of the through-hole in the third core and the penetration direction of the through-hole in the fourth core are perpendicular to each other, this embodiment is configured such that the penetration direction of a through-hole in the third core 210 and the penetration direction of a through-hole in the fourth core 240 are parallel to each other.

In this embodiment, a third coil 220 and a fourth coil 250 are continuously and integrally formed, similar to the first embodiment.

Similar to the second embodiment, a base is of a separation type, and includes a first base 230 and a second base 260.

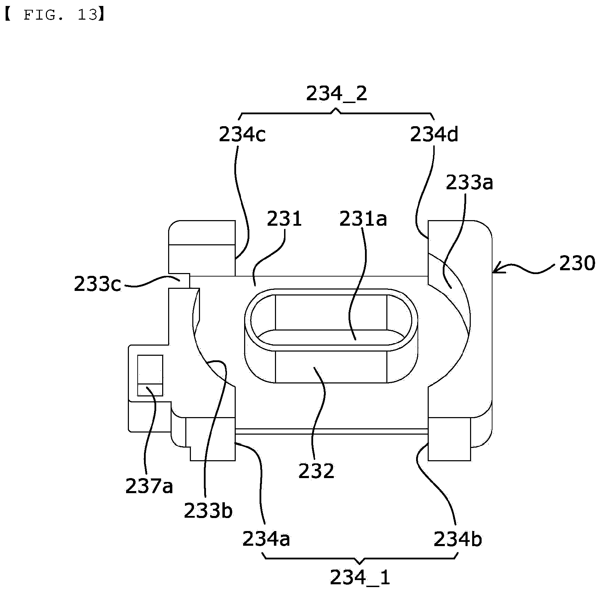

First, the first base 230 will be described in detail with reference to FIG. 13.

The first base 230 includes a third-coil-seating portion 231, in which a through-hole 231a is formed to allow a center leg of the third core 210 to pass therethrough and a flat surface is formed around the through-hole 231a to allow the third coil 220 to be seated thereon.

An inner side wall 232 is formed on the inner circumference of the third-coil-seating portion 231 so as to surround the through-hole 231a, and outer side walls 233a and 233b are formed on the outer circumference of the third-coil-seating portion 231.

A path slot 233c is formed in one side of the outer side wall 233b so that the flat wire coil escaping from the third core 210 after being spirally wound in the downward direction in the third core 210 passes through the outer side wall 233b.

Outer-leg-slot portions 234_1 and 234_2 in which a pair of outer legs of the third core 210 is located are formed in both sides of the third-coil-seating portion 231.

In addition, the outer-leg-slot portions 234_1 and 234_2 include extension walls 234a, 234b, 234c, and 234d extending laterally from the outer side walls 233a and 233b.

That is, as shown in FIG. 8, the first outer-leg-slot portion 234_1 includes a pair of extension walls 234a and 234b protruding and extending laterally from the outer side walls 233a and 233b so as to be disposed with one outer leg interposed therebetween. In addition, the second outer-leg-slot portion 234_2 includes a pair of extension walls 234c and 234d protruding and extending laterally from the outer side walls 233a and 233b so as to be disposed with the other outer leg interposed therebetween.

When the third core 210 and the first base 230 are assembled with each other, the center leg of the third core 210 is inserted into the through-hole 231a in the third-coil-seating portion 231, and the pair of outer legs of the third core 210 is located in the outer-leg-slot portions 234_1 and 234_2, respectively, whereby the third-coil-seating portion 231 is disposed in the third core 210.

A first coil hole 237a into which one end portion of the flat wire coil of the third coil 220 is inserted is formed in one side of the first base 230.

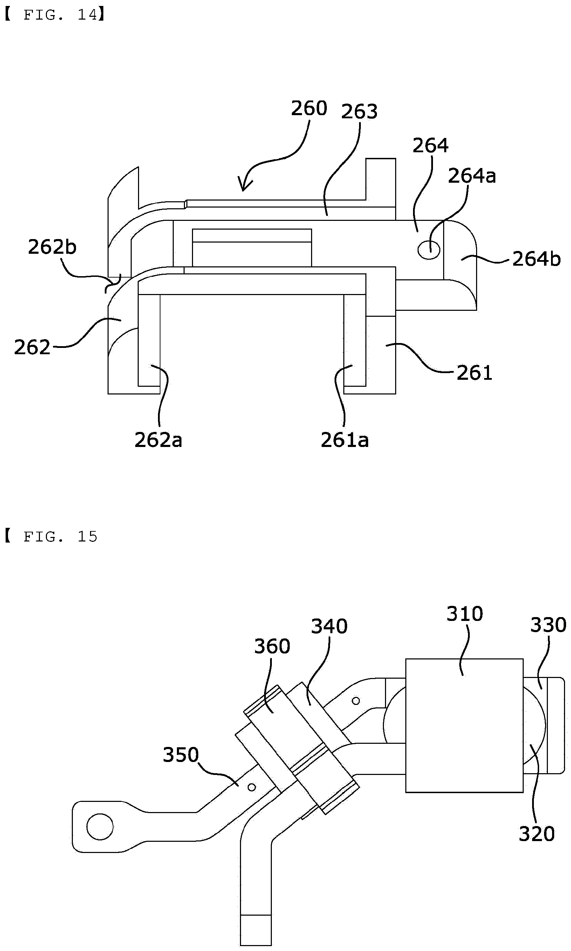

As shown in FIG. 14, the second base 260 includes fourth-core-seating portions 261, 261a, 262, and 262a, on which the fourth core 240 is seated and supported.

The fourth-core-seating portions 261, 261a, 262, and 262a include a pair of vertical walls 261 and 262 disposed with the fourth core 240 interposed therebetween, and seating protrusions 261a and 262a protruding from the lower ends of the respective vertical walls 261 and 262 to allow the fourth core 240 to be seated and supported thereon.

In addition, the second base 260 includes a fourth-coil-seating portion 263, which penetrates the fourth core 240 and is formed to interconnect the pair of vertical walls 261 and 262 and on which the fourth coil 250 is seated.

In the second base 260, a coil-receiving recess 262b in which an end portion of the fourth coil 250 is received is formed in the outer surface of the vertical wall 262. In addition, a pin portion 264, which further extends from the fourth-coil-seating portion 263 and includes a pin hole 264a, is formed on the outer surfaces of the other vertical walls 261 and 262. The pin portion 264 includes a curved portion 264b formed on an edge of the upper end thereof to guide bending of the coil, which will be described later.

Due to the above-described structures of the first base 230 and the second base 260, the flat wire coil forming the third coil 220 passes through the first coil hole 237a from below to above, is bent horizontally to enter an upper portion in the third core 210, is spirally wound around the center leg of the third core 210 in the downward direction, and then is seated on the bottom of the third-coil-seating portion 231. Subsequently, the flat wire coil passes through the path slot 233c in the outer side wall 233b, is bent upward, and then is bent horizontally to be placed on the pin portion 264 and to be seated and supported on the fourth-coil-seating portion 263. Subsequently, the flat wire coil passes through the fourth core 240, is bent downward to be received in the coil-receiving recess 262b, and extends downward.

### Fourth Embodiment of Output Inductor and EMI Inductor

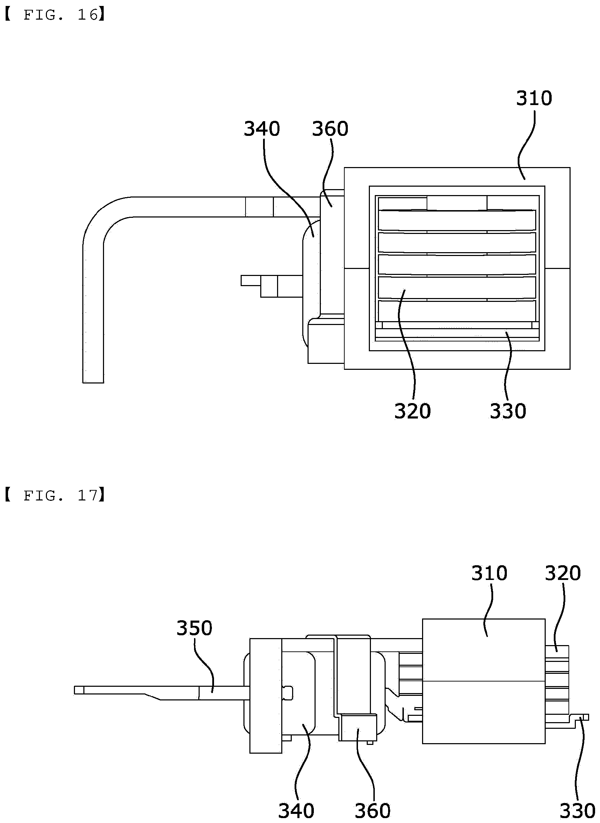

FIGs. 15 and 16 show a fourth embodiment of the output inductor and the EMI inductor, which will be described below.

In this embodiment, the structures of a third core 310 and a fourth core 340 are the same as those in the first embodiment, and therefore, detailed description thereof will be omitted.

In this embodiment, the third core 310 and the fourth core 340 are disposed so as to overlap each other in the horizontal direction (the second direction). However, in this embodiment, the penetration direction of a through-hole in the third core 310 and the penetration direction of a through-hole in the fourth core 340 form a predetermined angle (about 45 degrees) therebetween.

In this embodiment, a third coil 320 and a fourth coil 350 are continuously and integrally formed, similar to the first embodiment.

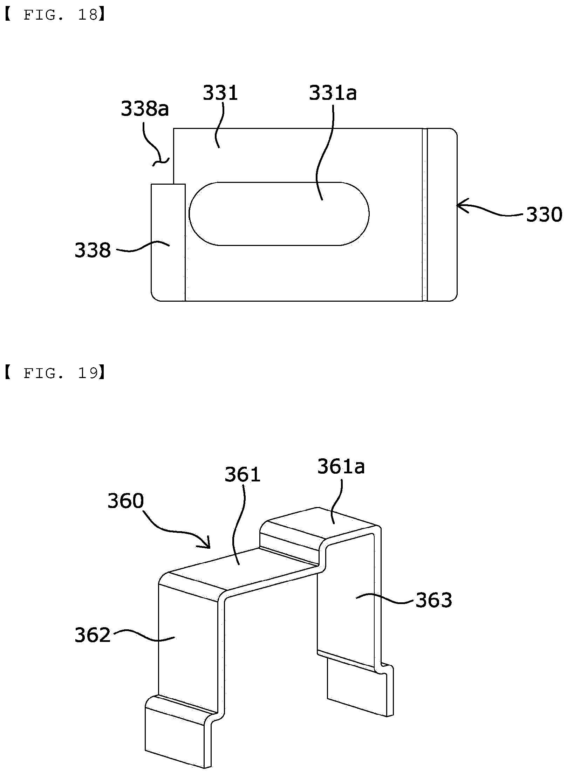

This embodiment includes a first base 330 and a bracket 360, the structures of which will be described below in detail with reference to FIGs. 18 and 19.

The first base 330 includes a third-coil-seating portion 331, in which a through-hole 331a is formed to allow a center leg of the third core 310 to pass therethrough and a flat surface is formed around the through-hole 331a to allow the third coil 320 to be seated and supported thereon.

In addition, the first base 330 includes a protruding portion 338, which is formed on one side of the third-coil-seating portion 331 so as to protrude to a height lower than the thickness of the flat wire coil of the third coil 320. Here, the protruding portion 338 includes a coil path slot 338a formed in one side thereof to allow the coil escaping from the third core 310 to pass therethrough.

The third coil 320 is placed on the upper surface of the fourth core 340 before entering the third core 310. The bracket 360 is formed so as to surround the upper surface and both side surfaces of the fourth core 340 in the state in which the third coil 320 is disposed on the fourth core 340.

The bracket 360 may have a shape in which a thin metal strip is bent, and includes an upper strip portion 361 and side strip portions 362 and 363 bent and extending from both sides of the upper strip portion 361 to be formed in a substantially U-shape.

Here, the upper strip portion 361 includes a protruding receiving portion 361a formed on one side thereof so as to protrude upward. The third coil 320 is placed on the upper surface of the fourth core 340, is received in the protruding receiving portion 361a, and is fixed by the bracket 360.

In this embodiment, the flat wire coil forming the third coil 320 is placed on the fourth core 340, is received in the protruding receiving portion 361a, enters an upper portion in the third core 310 at the same height, is spirally wound around the center leg of the third core 310 in the downward direction, and then is seated on the bottom of the third-coil-seating portion 331. Subsequently, the flat wire coil passes through the path slot 338a, is bent upward, and then is bent horizontally to penetrate the fourth core 340.

Here, as shown in FIG. 15, the end portion of the fourth coil 350 may increase in planar area to include a bus bar structure including a through-hole formed in the center thereof.

### Embodiment of ZVS Inductor and Transformer

FIGs. 20 to 22 show an embodiment of the ZVS inductor and the transformer according to the present disclosure, which will be described below.

In this embodiment, the transformer is a ZVS-inductor-integrated transformer with which the ZVS inductor is integrally formed.

A first core 70 is formed in such a manner that an upper core portion 71 and a lower core portion 72 contact each other, and has the same shape as the third core 10 in the first embodiment, and therefore, detailed description thereof will be omitted.

Further, a second core 80 has substantially the same shape as the upper core portion 71 of the first core 70.

In this embodiment, the second core 80 is disposed above the first core 70, and the second core 80 and the first core 70 overlap each other in the vertical direction (the first direction).

A first coil 73 is disposed in the first core 70 so as to be wound around a center leg of the first core 70 to form a primary coil 73, and a secondary coil 74 is disposed in the first core 70 so as to surround the center leg in a state of being separated and electrically isolated from the primary coil 73.

In this embodiment, the secondary coil 74 is implemented as a plurality of conductive plates, but the disclosure is not limited thereto.

The first coil 73, which constitutes the primary coil 73, enters a lower portion in the first core 70, is spirally wound in the upward direction, and then escapes from the first core 70. Subsequently, the first coil 73 enters the second core 80, is wound around the center leg of the second core 80, and then escapes from the second core 80.

That is, in this embodiment, the first coil 73 and a second coil 81 are integrally formed in such a manner that a single coil wire is continuously wound.

In this embodiment, a bobbin or a base structure, which is a plastic injection-molded product for electrical isolation between the primary coil 73 and the secondary coil 74, is omitted from the transformer.

A more compact structure may be realized through omission of a bobbin or a base structure.

### [Mode for Invention]

Various embodiments have been described in the best mode for carrying out the disclosure.

## Claims

1. A circuit board, comprising:
a board including a circuit unit formed thereon;
a first module disposed on the board; and
a second module disposed on the board so as to be adjacent to the first module and configured to be electrically connected to the first module via the circuit unit,
wherein the first module includes:
a transformer including a first core and a first coil disposed in the first core and including primary and secondary coils in order to convert power on an input side and to transmit the converted power to an output side; and
a ZVS inductor disposed adjacent to the transformer, the ZVS inductor including a second core and a second coil disposed in the second core in order to return a residual current to the input side,
wherein the second module includes:
an output inductor including a third core and a third coil disposed in the third core in order to remove ripple components included in a current on the output side; and
an EMI inductor disposed adjacent to the output inductor, the EMI inductor including a fourth core and a fourth coil disposed in the fourth core in order to reduce electrical noise included in the current on the output side,
wherein the first coil and the second coil are configured to be electrically connected to each other, and at least partially overlap each other in a first direction from the first core toward the second core,
wherein the third coil and the fourth coil are configured to be electrically connected to each other via the circuit unit, and the third core and the fourth core at least partially overlap each other in a second direction perpendicular to the first direction, and
wherein the first core includes a material identical to a material of the second core, and the second core includes a material different from a material of at least one of the third core and the fourth core.

2. The circuit board according to claim 1, wherein the first and second cores include ferrite, and
wherein the third and fourth cores include iron (Fe) and silicon (Si).

3. The circuit board according to claim 1, further comprising:
a first base at least partially disposed in the third core, the first base being configured to receive the third coil; and
a second base configured to receive the fourth core.

4. The circuit board according to claim 3, wherein the first base includes:
a third-coil-seating portion including a through-hole formed therein to allow a center leg of the third core to pass therethrough, the third-coil-seating portion being configured to allow the third coil to be seated thereon;
an inner side wall formed on the third-coil-seating portion so as to surround the through-hole; and
an outer side wall formed on an outer circumference of the third-coil-seating portion, the outer side wall including a coil path slot formed therein to allow a flat wire coil escaping from the third core to pass therethrough.

5. The circuit board according to claim 4, wherein the first base includes a pair of third-core-outer-leg-slot portions formed in both sides of the third-coil-seating portion to allow a pair of outer legs of the third core to be inserted thereinto and located therein.

6. The circuit board according to claim 5, wherein each of the third-core-outer-leg-slot portions includes a pair of first extension walls extending from the outer side wall in an outward direction, with the outer legs interposed therebetween.

7. The circuit board according to claim 5, wherein the first base includes a first coil hole formed in one side of the third-coil-seating portion, and
wherein the third coil is disposed so as to be inserted into the first coil hole.

8. The circuit board according to claim 5, wherein the first base further includes a fastening portion extending outside the third core from the third-coil-seating portion and including at least one fastening hole formed therein.

9. The circuit board according to claim 3, wherein the second base includes:
a fourth-core-seating portion configured to allow the fourth core to be seated and supported thereon; and
a fourth-coil-seating portion configured to allow the fourth coil to be seated thereon,
wherein the fourth-core-seating portion includes a pair of vertical walls disposed with the fourth core interposed therebetween, and a seating protrusion protruding from a lower end of each of the vertical walls to support the fourth core seated thereon, and
wherein the fourth-coil-seating portion is formed so as to interconnect the pair of vertical walls in the fourth core.

10. The circuit board according to claim 9, wherein the second base includes a pin portion extending from the fourth-coil-seating portion and including a pin hole formed therein.

11. The circuit board according to claim 3, wherein the first base and the second base are integrally formed with each other.

12. The circuit board according to claim 3, wherein the first base includes a third-coil-seating portion including a through-hole formed therein to allow a center leg of the third core to pass therethrough, the third-coil-seating portion being configured to allow the third coil to be seated thereon, and a protruding portion protruding from one side of the third-coil-seating portion to a height lower than a thickness of a coil wire of the third coil and including a coil path slot formed therein to allow the third coil escaping from the third core to pass therethrough.

13. The circuit board according to claim 12, wherein one end portion of the third coil is disposed above the fourth core, and
wherein the circuit board further comprises a bracket configured to surround an upper surface and both side surfaces of the fourth core in a state in which the third coil is disposed above the fourth core.

14. The circuit board according to claim 1, wherein the third coil and the fourth coil are continuously formed using a single flat wire coil disposed so as to enter the third core, to be spirally wound around a center leg of the third core in a downward direction, to escape from the third core, and to be bent upward to penetrate the fourth core.

15. The circuit board according to claim 2, wherein the third core further includes nickel (Ni), and
wherein the fourth core further includes boron (B).
